# EUROPÄISCHE PATENTANMELDUNG

(11) **EP 0 936 283 A1**
(43) Veröffentlichungstag der Anmeldung: **18.08.1999**
(21) Anmeldenummer: 98121949.6
(22) Anmeldetag: 19.11.1998
(51) Int. Cl.: C23C 16/30, C23C 16/50, B65D 1/00

(54) **Barriereschicht für Verpackungsmaterial und Verfahren zu dessen Herstellung**

(30) Priorität: 23.01.1998 DE 19802333
(71) Anmelder: Leybold Systems GmbH, D-63450 Hanau am Main (DE)
(72) Erfinder: Grünwald, Heinrich, Dr., 61194 Niddatal (DE)

(57) **Zusammenfassung**

Die Erfindung behandelt ein Verfahren zur Herstellung von Barriereschichten (4) für Gase und Dämpfe auf Kunststoffsubstraten (2), insbesondere Kunststoffolien und -formkörper. Hierzu wird auf dem Substrat (2) mittels eines Gasphasenabscheideverfahrens mindestens eine Barriereschicht (4) aufgebracht, die aus einer anorganischen Matrix, bestehend aus einem Oxid, z. B. Silizium-, Bor-, Aluminium-, Titan- oder Zinnoxid, einem Nitrid oder Oxinitrid sowie einem Kohlenstoffanteil besteht oder alternativ auch einen Anteil eines Metalls aufweist. Die Barriereschicht (4) wird mittels eines PCVD-Abscheideprozesses unter Verwendung eines die obigen Substanzen enthaltenden Reaktivgases und unter Zufuhr von Mikrowellenenergie auf dem Kunststoffsubstrat (2) abgeschieden. Die derartig erzeugten Schichten (4) weisen eine hohe Sperrwirkung gegenüber der Permeation von Gasen, insbesondere gegenüber Kohlenwasserstoffen, Sauerstoff, Kohlendioxid und Wasserdampf auf. Die Barriereschichten (4) werden zur Herstellung von dünnwandigen Verpackungen, wie z. B. Folien oder zur Herstellung von Behälterwandungen für z. B. CO₂-haltige Erfrischungsgetränke aufnehmende Behälter verwendet.

## Beschreibung

Die Erfindung betrifft eine für sichtbares Licht und Mikrowellen transparente Barriereschicht auf Kunststoffsubstraten, welche die Permeation von gasförmigen und/oder flüssigen Stoffen, insbesondere von Kohlenwasserstoffen, Sauerstoff, Wasserdampf und von CO₂, durch das beschichtete Substrat hemmt.

Die für Verpackungen oder als Behälter üblicherweise verwendeten Kunststoffe sind in aller Regel nicht hinreichend diffusionsdicht für flüchtige Substanzen wie Kohlenstoffe oder Aromen und Duftstoffe sowie gegenüber Gasen wie Kohlenwasserstoff, Sauerstoff, Kohlendioxid und Wasserdampf. Dieses macht sich insbesondere bei dünnwandigen Verpackungen, wie z. B. Folien oder unter Gasdruck stehenden Verpackungen, welche z. B. CO₂-haltige Erfrischungsgetränke enthalten, besonders nachteilig bemerkbar.

Es ist deshalb bekannt, Kunststoffverpackungen mit Diffusionsbarriereschichten zu versehen. Optisch transparente Barriereschichten werden in bekannter Weise durch Aufdampfen von Metalloxiden, meist Al₂O₃ oder unterstöchiometrisches Siliziumoxid, SiOₓ, auf die Substratoberflächen hergestellt.

Alternativ werden auch quarzähnliche SiO₂-Schichten durch einen plasmachemischen Gasphasenabscheidungsprozeß ("Plasma Chemical Vapor Deposition", PCVD) aus einer Organosiliziumverbindung mit einem Überschuß an Sauerstoff unter Zusatz von Helium hergestellt, wie der Veröffentlichung J. T. Felts: "Transparent Gas Barrier Technologies", Society of Vacuum Coaters 33^{rd} Ann. Tech. Conf. Proc. (1990), 184-193 und der EP 299 754 B1 zu entnehmen ist. Die mittels PCVD-Verfahren hergestellten SiO₂-Schichten weisen gegenüber aufgedampften SiOₓ-Schichten eine höhere optische Transparenz und eine deutlich verbesserte Sperrwirkung und auch Reißfestigkeit auf. Nachteilig ist jedoch, daß mit der gemäß diesen zitierten Arbeiten verwendeten Plasmaerzeugung durch eine Anregungsfrequenz von ca. 40 kHz mit Magnetfeldverstärkung nur eine niedrige Beschichtungsrate erzielt werden kann, die dieses Verfahren für viele Anwendungen unwirtschaftlich macht, da der Beschichtungsvorgang zeitaufwendig ist.

In der PCT/US 97/05061 wird die Herstellung von Barriereschichten gegen Sauerstoff, Wasserdampf und Kohlendioxid beschrieben, wobei ein Kunststoffmaterial mit amorphem Nylon vorbeschichtet wird und anschließend durch ein PCVD-Verfahren mit einer Silizium- oder Aluminiumoxidschicht oder einer Mischung hieraus beschichtet wird.

Nach der EP 0 460 796 A2 wird die Barrierewirkung gegen Sauerstoff und Wasserdampf einer mit einem Vakuumverfahren, nämlich durch Bedampfen und Kathodenzerstäubung aufgebrachten, glasartigen SiO₂-Schicht verbessert, indem mindestens ein Metall aus der Gruppe Antimon, Aluminium, Chrom, Kobalt, Kupfer, Indium, Eisen, Blei, Mangan, Zinn, Titan, Wolfram, Zink und Zirkonium in die Schicht eingelagert wird.

In der DE 44 04 690 A1 wird ein Verfahren zur Erzeugung von Sperrschichten auf Kunststoffsubstraten gegen Gase und Dämpfe angegeben, bei dem ein Schichtsystem bestehend aus mindestens zwei Schichten, nämlich mindestens einer Grundschicht und einer Deckschicht, aufgebracht wird. Hierbei wird die Grundschicht als siliziumorganische, also kohlenstoffhaltige Schicht mittels PCVD aus einem siliziumhaltigen Reaktivgas und die Deckschicht mit einem beliebigen Vakuumbeschichtungsverfahren, wie z. B. Aufdampfen, Kathodenzerstäubung oder bevorzugt PCVD, als kohlenstoffarme Metalloxidschicht aufgebracht. Zur Durchführung der PCVD-Prozesse wird dem Plasma unter Einwirkung elektromagnetischer Strahlung mit einem Radiofrequenzmagnetron Energie zugeführt.

In der DE 44 38 359 A1 wird ein ähnliches Schichtsystem auf Kunststoffbehältern beschrieben, das sich aus sequentiell angeordneten organischen und auch siliziumorganischen Polymeren sowie aus anorganischen Oxiden zusammensetzt. Die Schichten werden mittels physikalischer Gasphasenabscheidung ("Physical Vapor Deposition", PVD) oder PCVD, insbesondere PICVD ("Plasma Impulse Chemical Vapor Deposition") hergestellt, wobei das Plasma durch Mikrowellen angeregt wird.

Den vorgenannten Verfahren ist gemeinsam, daß die Sperrschichten im wesentlichen SiO₂ enthalten, das sich nachteilig nicht mit den gewünschten hohen Beschichtungsraten aufbringen läßt und das als Einzelschicht auch keine ausreichende Barrierewirkung z. B. gegen CO₂ aufweist.

In der US 5,041,303 wird die Herstellung von Barriereschichten gegen Gase und Dämpfe mittels eines mikrowellenerzeugten Plasmas beschrieben, wobei als Applikator zur Übertragung der Mikrowellen in die Reaktionskammer eine sogenannte "slow wave structure" wesentlich ist. Eigene Versuche mit dieser Vorrichtung haben jedoch ergeben, daß diese Art der Mikrowelleneinspeisung zu einer nicht erwünschten, nämlich ungleichmäßigen Beschichtung der Substrate neigt, so daß zwei dieser Vorrichtungen gegenläufig angeordnet werden müssen, um diesen Nachteil zu kompensieren und mit der zusätzlichen Maßnahme, daß das zu beschichtende Kunststoffmaterial an dieser doppelten slow wave structure vorbeibewegt werden muß. Die Lösungen sind unvorteilhaft im Sinne erhöhten Aufwands, da sich die bekannten Maßnahmen zur Erzeugung von gattungsgemäßen Barriereschichten insgesamt als zu aufwendig erweisen und damit nicht wirtschaftlich durchführbar sind.

Der Erfindung liegt die Aufgabe zugrunde, ein Verfahren anzugeben, das mit hoher Beschichtungsrate und geringem apparativem Aufwand die Herstellung einer transparenten, reißfesten Barriereschicht mit hoher Sperrwirkung gegen den Durchtritt von gasförmigen und/oder flüssigen Substanzen, wie z. B. Sauerstoff, Wasserdampf, insbesondere Kohlenwasserstoffe und Kohlendioxid, auf Kunststoffmaterialien ermöglicht. Das Verfahren soll darüber hinaus die Möglichkeit bieten, bereits mit nur einer einzigen Barriereschicht die gewünschte Barrierewirkung zu erzielen.

Weiterhin soll eine nach diesem Verfahren hergestellte Barriereschicht geschaffen werden, die eine erhöhte Sperrwirkung im Vergleich zu den aus dem Stand der Technik bekannten Barriereschichten aufweist.

Erfindungsgemäß wird die Aufgabe des Verfahrens dadurch gelöst, daß mittels eines mikrowellenangeregten PCVD-Verfahrens auf den zu beschichtenden Kunststoffmaterialien eine Barriereschicht aufgebracht wird, die aus mindestens einer im wesentlichen anorganischen Matrix, bestehend aus einem Oxid, vorzugsweise Silizium-, Bor-, Aluminium-, Magnesium-, Titan- oder Zinnoxid, einem Nitrid oder Oxinitrid, bevorzugt Siliziumnitrid oder Siliziumoxinitrid, oder einer aus diesen mit Phosphoroxid zusammengesetzten Mischverbindung und einem Kohlenstoffanteil besteht. Der Kohlenstoffanteil besteht typischerweise aus einer Kohlenwasserstoffverbindung. Er kann aber auch in anderer Form, z. B. als Carbid, in die Matrix eingelagert sein. Der Einbau von Kohlenstoff- bzw. von Kohlenwasserstoffkomponenten in die Matrix bewirkt vorteilhaft eine Erhöhung der Reißfestigkeit der Barriereschicht.

Eine besonders effektiv wirksame Barriereschicht ergibt sich mit den Merkmalen nach Patentanspruch 2, nämlich indem die Barriereschicht einen Anteil mindestens eines weiteren Metalls im folgenden "Zusatzmetall" genannt, aufweist, wobei die Metalle Kupfer und/oder Zink explizit als Zusatzmetall von der erfindungsgemäßen Lösung ausgenommen werden.

Das zusätzlich in die Matrix eingebaute Zusatzmetall hat die Funktion, die Sperrwirkung weiter zu verstärken. In welcher Art die Verbindung zwischen dem Zusatzmetall und der Matrix dargestellt ist, ist nicht im einzelnen verstanden. Es wird jedoch angenommen, daß das Zusatzmetall in Form einzelner Atome oder in Atomgruppen, die jeweils auch ionisiert sein können, größere Lücken innerhalb der Matrix besetzt und diese dergestalt ausfüllt wodurch die Barrierewirkung verbessert wird.

Ein zusätzlicher Vorteil der derartig hergestellten Barriereschicht entsteht dadurch, daß es erfindungsgemäß nicht erforderlich ist, eine annähernd reine anorganische Matrix herzustellen. Hierdurch kann der PCVD-Prozeß vorteilhaft mit einer höheren Beschichtungsrate gegenüber solchen der Herstellung reiner Matrizen durchgeführt werden.

Erfindungsgemäß ist es auch möglich, eine Barrierebeschichtung aus mehreren, unterschiedlichen Matrizen mit unterschiedlichen Kohlenstoffanteilen und/oder unterschiedlichen Zusatzmetallen, die in unterschiedlichen Schichtanteilen vorliegen können, aufzubauen, wie in Patentanspruch 3 angegeben.

Die erfindungsgemäß hergestellte Schichtfolge besteht somit aus mindestens einer einzigen Schichtlage, welche mittels eines PCVD-Verfahrens hergestellt wird und wobei als Ausgangsstoffe
a.) mindestens eine genügend flüchtige Metall-oder Halbmetallverbindung, welche die Matrix bildet, und
b.) mindestens eine genügend flüchtige Kohlenstoffverbindung.
verwendet werden und wobei die Schicht unter Plasmaanregung mit Hilfe von Mikrowellen hergestellt wird.

Weitergebildete Barriereschichten, welche eine noch größere Sperrwirkung als die vorgenannten aufweisen, und nach dem erfindungsgemäßen Verfahren hergestellt werden, bestehen erfindungsgemäß aus mindestens einer einzigen Schichtlage, welche mittels eines PCVD-Verfahrens hergestellt wird und wobei als Ausgangsstoffe
a.) mindestens eine genügend flüchtige Metall-oder Halbmetallverbindung, welche die Matrix bildet, und
b.) mindestens eine genügend flüchtige Kohlenstoffverbindung und
c.) mindestens eine genügend flüchtige Verbindung mindestens eines weiteren Metalls, des Zusatzmetalls,mit Ausnahme der Metalle Kupfer und/oder Zink,
verwendet werden und wobei die Schicht unter Plasmaanregung mit Hilfe von Mikrowellen hergestellt wird.

Unter genügend flüchtigen Verbindungen werden solche Verbindungen verstanden, welche bei einer Temperatur von maximal 140°C einen Dampfdruck von größer als 0,2 mbar aufweisen.

Hierbei wird der Beschichtungsprozeß erfindungsgemäß so durchgeführt, daß die Barriereschicht insgesamt einen Kohlenstoffanteil von mindestens 1 Atom% und maximal 10 Atom%, bezogen auf alle Elemente außer Wasserstoff, und einen Anteil von Zusatzmetall in Höhe von mindestens 1 Atom% und maximal 10 Atom%, vorzugsweise zwischen 1 Atom% und 6 Atom%, enthält.

Bevorzugt werden die unter a.) genannten Metall- oder Haltmetallverbindungen und die unter b.) genannten Kohlenstoffverbindungen zusammen in Form einer chemischen Verbindung dem Plasma zugeführt. D. h. es wird mindestens eine metall- oder halbmetall-organische Verbindung, z. B. eine silizium-, bor-, aluminium-, magnesium-, titan- oder zinnorganische Verbindung als Schichtbildner eingesetzt.

Weiterhin wird vorgeschlagen, metall- oder halbmetallorganische Verbindungen zu verwenden, die frei von Halogenen, insbesondere frei von Chlor und Brom sind. Insbesondere soll auf den Einsatz von Metall- oder Halbmetallhalogeniden mit dem ansonsten erhöhten Aufwand für den Schutz der verwendeten Plasmabeschichtungsanlage, des Bedienungspersonals und der Umwelt verzichtet werden.

Bevorzugt besteht die flüchtige Zusatzmetallverbindung aus einer halogenfreien, metallorganischen Verbindung, beispielsweise einer Indium-, Blei-, Kobalt-, Eisen-, Mangan-, Chrom-, Nickel-, Vanadium-, Molybdän-, Wolfram-, Zirkonium- oder aus einer Hafnium- oder Cerorganischen Verbindung. Es ist weiterhin vorgesehen, eine der unter a.) genannten Metallverbindungen auch als Zusatzmetall einzusetzen. Auch ist die Verwendung von Metallcarbonylen oder Zusatzmetallcarbonylen erfindungsgemäß möglich.

Zur Herstellung der erfindungsgemäßen Barriereschicht auf Kunststoffmaterialien weisen diese während der Dauer des Beschichtungsprozesses vorteilhaft eine Substrattemperatur nahe der Raumtemperatur auf.

Eine bessere Barrierewirkung der Schicht läßt sich dadurch erzielen, daß das Kunststoffmaterial vorgewärmt wird und im erwärmten Zustand beschichtet wird oder daß der Beschichtungsprozeß derartig geführt wird, daß das Kunststoffmaterial durch die Einwirkung des Plasmaprozesses selbst erwärmt wird. Der bevorzugte Temperaturbereich liegt hierbei zwischen 50°C und 110°C. Die optimale Substrattemperatur ist dabei einerseits abhängig von der Temperaturstabilität des Substratmaterials und andererseits von der Differenz der thermischen Ausdehnungskoeffizienten der Beschichtung und des Substratmaterials.
Weiterhin wird vorgeschlagen, die Substarte 2-seitig zu beschichten, wodurch die Sperrwirkung der beschichteten Substrate vorteilhaft erhöht wird (siehe Patentanspruch 5).
Weiterbildende Merkmale des erfindungsgemäßen Herstellverfahrens sind in den übrigen der Unteransprüchen 2 bis 7 und Merkmale der erfindungsgemäßen Barriereschicht in den übrigen der Unteransprüchen 8 bis 11 angegeben.

Die Erfindung wird im folgenden anhand in Figuren dargestellter, besonders bevorzugter Ausführungsbeispiele näher beschrieben. Es zeigen:
- Fig. 1: eine Querschnittsansicht einer erfindungsgemäßen einlagigen Barriereschicht auf einem Kunststoffsubstrat,
- Fig. 2: die Querschnittsansicht einer erfindungsgemäßen, aus drei Einzelschichten bestehenden Barriereschicht auf einem Substrat und
- Fig. 3: eine Querschnittsansicht einer Beschichtungsvorrichtung zum Abscheiden von erfindungsgemäßen PCVD-Barriereschichten auf Behälteraußenflächen im Längsschnitt.

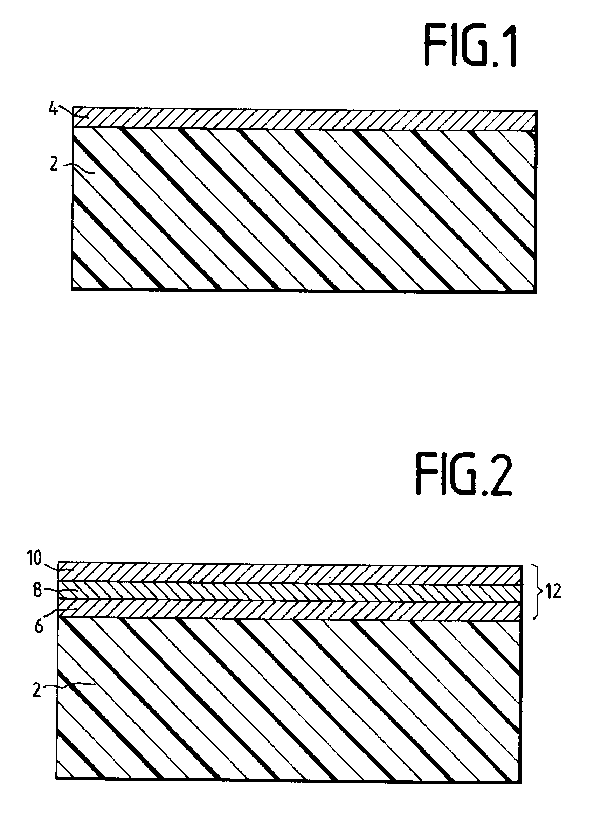

Die in Fig. 1 dargestellte Barriereschicht 4 besteht aus einem einlagigen Schichtauftrag, welcher mittels eines PCVD-Beschichtungsverfahrens auf einem Kunststoffsubstrat 2 abgeschieden ist. Die Zusammensetzung der Barriereschicht 4 wurde mit der Röntgenphotoelektronenspektroskopie (XPS) quantitativ bestimmt und weist eine Zusammensetzung von 30 Atom% Silizium, 65 Atom% Sauerstoff, 2 Atom% Kohlenstoff und 3 Atom% Vanadium als Zusatzmetall auf. Eventuell vorhandene Wasserstoffanteile in der abgeschiedenen Schicht 4 werden durch die XPS-Analyse allerdings nicht erfaßt. Die Schichtdicke der einlagigen Barriereschicht 4 beträgt 45 nm.

Ein mehrlagiges Schichtensystem 12 ist in Fig. 2 dargestellt. Hierzu wurden auf einem Kunststoffsubstrat 2 die einzelnen Barriereschichten 6, 8, 10 nacheinander mittels eines PCVD-Verfahrens abgeschieden. Die quantitative Zusammensetzung der Schichten 6,8,10 wurde mittels XPS gemessen. Die Element-Zusammensetzung ohne Beücksichtigung der Wasserstoffanteile der einzelnen Schichten 6,8,10 ist in Atom% in der nachstehenden Tabelle 1 aufgelistet. Weiterhin ist der Tabelle 1 die Dicke der Einzelschichten 6,8,10 wie gemessen zu entnehmen.

**Tabelle 1**

| Schicht | Si | O | C | Sn | V | Dicke [nm] |
|---|---|---|---|---|---|---|
| 6 | 35 | 55 | 9 | - | 1 | 35 |
| 8 | - | 61 | 7 | 32 | - | 15 |
| 10 | 30 | 63 | 2 | - | 5 | 20 |

Bei dem sowohl in Fig. 1 als auch Fig. 2 verwendeten Substrat 2 handelt es sich um aus PET (Polyethylenterephthalat) bestehende Kunststoffolie.

Mit dem erfindungsgemäßen Verfahren lassen sich die hier vorgeschlagenen Schichten auch auf die Wandflächen von aus Kunststoff bestehenden Behältern, z. B. Getränkeflaschen, aufbringen.

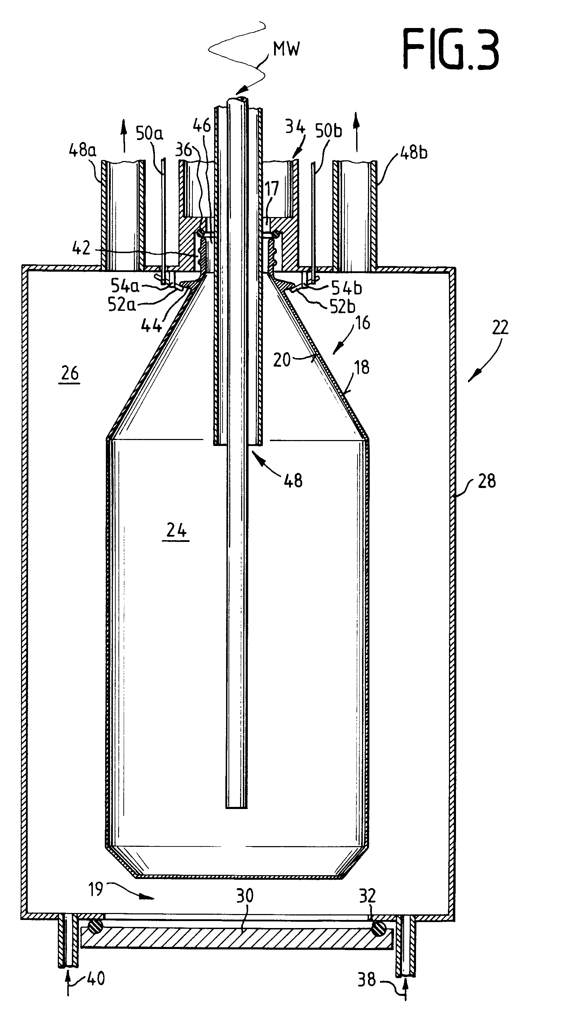

In Fig. 3 ist eine zur Herstellung von Barriereschichten auf Flaschen geeignete Beschichtungsvorrichtung dargestellt, mittels welcher die Außenflächen von einem eine Öffnung 17 aufweisenden Behälter 16 mittels eines plasmagestützten PCVD-Verfahrens zu beschichten sind. Die Beschichtungsvorrichtung umfaßt eine evakuierbare Beschichtungskammer 22, welche durch in die Kammerwand 28 eingelassene Abpumpstutzen 48a, 48b mittels in der Fig. 3 nicht dargestellter Vakuumpumpen evakuierbar ist. Zum Beschicken der Beschichtungskammer 22 weist diese eine Bodenöffnung 19 auf, welche mittels eines Deckels 30 verschließbar ist, der auf einem Dichtungselement 32 an der Kammerwand 28 an-liegt und die Beschichtungskammer 22 vakuumdicht abschließt.

Zum Beschichten der Außenfläche 18 des Behälters 16 wird dieser über die Bodenöffnung 19 in die Beschichtungskammer 22 eingebracht und die Beschichtungskammer 22 anschließend vakuumdicht verschlossen. Der Behälterhals ist konisch zulaufend und weist öffnungsseitig ein Außengewinde auf (siehe Fig. 3). Der Behälter 16 wird mit seiner Öffnung 17 in einem Dichtkopf 34 fixiert und liegt mit seiner umlaufenden, öffnungsseitigen Dichtfläche 46 an einem im Dichtkopf 34 angeordneten Dichtungselement 36 an. Um einen gegenüber dem Innenraum der Beschichtungskammer 22 , d.h. dem Behälteraußenraum 26, vakuumdichten Übergang zum Behälterinnenraum 24 zu gewährleisten, wird der Behälter 16 an einem am Behälter 16 angeformten, vorzugsweise umlaufenden Kragen 44 gegen das Dichtungselement 36 gepreßt, wobei der Behälter 16 mittels Betätigungsstangen 50a, 50b , Verrieglungselementen 52 a, b und zugeordneten, am Dichtkopf 34 fixierter Wipplager 54a, b angepreßt wird.

Zum Zünden eines Plasmas im Behälteraußenraum 26 wird in diesem über Gaseinlässe 38, 40 ein Prozeßgas eingelassen, wobei der für die Zündung des Plasmagases und den Betrieb des Plasmas benötigte Gasdruck von ca. 22 Pa eingestellt wird. Dieses Prozeßgas besteht aus Anteilen von Tetramethyldisiloxan, Sauerstoff und Vanadiumtriisoproxyoxid, vorzugsweise aus 15% Tetramethyldisiloxan, 77% Sauerstoff und 8% Vanadiumtriisoproxyoxid. Zum Zünden des Plasmas wird Mikrowellenstrahlung MW einer Wechselfrequenz von 220 MHz bis 22 GHz über eine Wellenleiteranordnung 48, welche im wesentlichen koaxial durch die Behälteröffnung 17 in den Behälter hineinragt, in den Behälterinnenraum 24 eingeleitet. In dem Behälterinnenraum 24 ist Atmosphärendruck eingestellt, der außerhalb des Zündbereiches des in dem Behälterinnenraum 24 befindlichen Gases liegt. Die Mikrowellenstrahlung MW wird im Behälterinneren 24 und vom Behälter 16 selbst nicht absorbiert und gelangt nahezu vollständig in den Behälteraußenraum 26, in welchem der geeignete Zündgasdruck des Prozeßgases eingestellt ist. Hierdurch wird bewirkt, daß das Plasma ausschließlich in dem Behälteraußenraum 26 zündet und die plasmagestützte plasmachemische Schichtabscheidung ausschließlich auf der Außenfläche 18 des Behälters 16 erfolgt.

Der Beschichtungsprozeß erfordert eine Plasmabrenndauer von ca. 12 Sekunden und wird durch das Abschalten der Mikrowelleneinstrahlung MW und / oder durch Unterbrechung der Zufuhr des Prozeßgases beendet. Im Anschluß an den Beschichtungsprozeß wird der Behälteraußenraum 26 über die Gaseinlässe 38, 40 belüftet und der Behälter 16 durch die Öffnung 19 entnommen.

### Bezugszeichenliste

- 2: Kunststoffsubstrat
- 4: Barriereschicht
- 6: Barriereschicht
- 8: Barriereschicht
- 10: Barriereschicht
- 12: Schichtsystem
- 16: Behälter, Hohlkörper
- 17: Öffnung
- 18: Außenfläche
- 19: Bodenöffnung
- 20: Innenfläche
- 22: Beschichtungskammer
- 24: Behälterinnenraum
- 26: Behälteraußenraum, Plasmaprozeßraum
- 28: Kammerwand
- 30: Deckel
- 32: Dichtungselement
- 34: Dichtkopf
- 36: Dichtungselement
- 38: Gaseinlaß
- 40: Gaseinlaß
- 42: Außengewinde
- 44: Behälterkragen
- 46: Dichtfläche
- 48: Wellenleiter, Antenne
- 50 a, b: Betätigungsstange
- 52 a, b: Verrieglungselement
- 54 a, b: Wipplager
- MW: Mikrowellenstrahlung

## Patentansprüche

1. Verfahren zur Herstellung von Barriereschichten für gasförmige und/oder flüssige Substanzen auf Substraten, insbesondere Kunststoffsubstraten, mittels eines plasmagestützten Gasphasenabscheideverfahrens, **dadurch gekennzeichnet**, daß auf dem Substrat (2) mindestens eine Schichtlage (4,6,8,10) einer anorganischen Schichtsubstanz mit einer Matrix bestehend aus einer Oxidverbindung oder aus einer Nitridverbindung sowie Kohlenstoffanteilen abgeschieden wird.

2. Verfahren nach Anspruch 1, **dadurch gekennzeichnet**, daß die Schichtlage (4,6,8,10) mit Anteilen von mindestens einem Metall oder mindestens einer Metallverbindung mit Ausnahme der Metalle Kupfer oder Zink abgeschieden wird.

3. Verfahren nach Anspruch 1 und/oder 2, **dadurch gekennzeichnet**, daß die Barriereschicht aus mindestens zwei Einzelschichten (6,8; 8,10; 6,10) besteht, welche sich in ihrer stöchiometrischen Zusammensetzung unterscheiden.

4. Verfahren nach mindestens einem der Ansprüche 1 bis 3, **dadurch gekennzeichnet**, daß optisch transparente und/oder mikrowellentransparente Barriereschichten (4,6,8,10) aufbringbar sind.

5. Verfahren nach mindestens einem der Ansprüche 1 bis 4, **dadurch gekennzeichnet**, daß die Substrate (2) ein- oder beidseitig beschichtet werden.

6. Verfahren nach mindestens einem der Ansprüche 1 bis 5, **dadurch gekennzeichnet**, daß dem zur Erzeugung der Barriereschichten (4,6,8,10) eingesetzten Plasma mittels elektromagnetischer Strahlung, vorzugsweise mittels Mikrowellenstrahlung Energie zugeführt wird.

7. Verfahren nach mindestens einem der Ansprüche 1 bis 6, **dadurch gekennzeichnet**, daß als Plasmaträgergas ein Edelgas verwendet wird.

8. Barriereschicht aufgebracht auf Substraten, vorzugsweise Kunststoffsubstraten, nach mindestens einem der Verfahrensansprüche 1 bis 7, **gekennzeichnet durch** mindestens eine Einzelschichtlage (4,6,8,10), welche eine anorganische Schichtsubstanz mit einer Matrixstruktur aufweist, die eine Oxidverbindung oder eine Nitridverbindung enthält und Kohlenstoff sowie Metall oder eine Metallverbindung aufweist.

9. Barriereschicht nach Anspruch 8, bestehend aus mindestens zwei Einzelschichten (6,8), welche jeweils eine unterschiedliche stöchiometrische Zusammensetzung aufweisen.

10. Barriereschicht nach Anspruch 8 und/oder 9, **dadurch gekennzeichnet**, daß die Barriereschicht (4,6,8,10) auf einer Kunststoffolie oder der Außenfläche (18) oder der Innenfläche (20) oder der Außenfläche (18) und der Innenfläche (18) eines Behälters (16) abgeschieden ist.

11. Barriereschicht nach mindestens einem der Ansprüch 8 bis 10, **dadurch gekennzeichnet**, daß die Schichtlage (4,6,8,10) Anteile von mindestens einem Metall oder mindestens einer Metallverbindung mit Ausnahme der Metalle Kupfer oder Zink aufweist.
